# EUROPÄISCHE PATENTANMELDUNG

(11) **EP 2 439 778 A1**
(43) Veröffentlichungstag der Anmeldung: **11.04.2012**
(21) Anmeldenummer: 11179699.1
(22) Anmeldetag: 01.09.2011
(51) Int. Cl.: H01L 31/0224, H01L 31/0236

(54) **Substrat mit texturierter Frontelektrodenschicht für eine Dünnschichtsolarzelle**

(30) Priorität: 06.10.2010 DE 102010047644; 24.11.2010 DE 102010052444
(71) Anmelder: SCHOTT Solar AG, 55122 Mainz (DE)
(72) Erfinder: Berginski, Michael, 45277 Essen (DE); Lechner, Peter, 85581 Vaterstetten (DE)
(74) Vertreter: von Puttkamer · Berngruber

(57) **Zusammenfassung**

Zur Herstellung einer Dünnschichtsolarzelle wird die Frontelektrodenschicht (3), die auf dem Substrat (1) abgeschieden ist, mit kegelförmigen Vertiefungen (4) texturiert, welche aus wenigstens zwei Abschnitten (4.1 und 4.2) mit unterschiedlichen Kegelöffnungswinkel (α1 und α2) bestehen, wobei der dem Substrat (1) zugewandte Abschnitt (4.1) der Vertiefungen (4) den größeren Kegelöffnungswinkel (α1) aufweist.

## Beschreibung

Die Erfindung bezieht sich auf ein Substrat mit einer darauf abgeschiedenen Frontelektrodenschicht zur Herstellung einer Dünnschichtsolarzelle sowie ein Verfahren zu dessen Herstellung nach dem Oberbegriff des Anspruchs 1.

Substrate mit einer solchen Frontelektrodenschicht sind bekannt. Die Texturierung der Frontelektrodenschicht mit den kegelförmigen Vertiefungen führt zu einer Erhöhung des Wirkungsgrades der Solarzelle, und zwar durch Lichtstreuung, durch die der optische Weg der einfallenden Sonnenstrahlung in der Halbleiterschicht verlängert wird sowie auf Grund der Reflexion der Strahlung an der Rückseite der Solarzelle durch Vielfachreflexion, dem sogenannten "Light Trapping".

Nach DE 197 13 215 A1 wird zur Herstellung einer solchen texturierten Frontelektrodenschicht beispielsweise auf einem Glassubstrat durch Sputtern eine Schicht aus Aluminium dotiertem Zinkoxid als transparentem, elektrisch leitfähigem Metalloxid abgeschieden, welche anschließend geätzt wird, um die kegelförmigen Vertiefungen zu bilden. Um zu verhindern, dass die Frontelektrodenschicht beim Ätzen vollständig abgetragen wird, kann die Zinkoxid-Schicht aus zwei verschieden schnell ätzbaren Teilschichten bestehen, und zwar die zuerst abgeschiedene Teilschicht als langsam ätzbare Ätzstopp-Schicht.

Insbesondere wenn auf der so texturierten Frontelektrodenschicht nano- oder mikrokristallines Silizium als Halbleiter abgeschieden wird, führt die durch die kegelförmigen Vertiefungen erzeugte Inhomogenität der Frontelektrodenschicht zu Verschneidungen und Rissen beim Aufwachsen der Halbleiterschicht und damit zu einer Herabsetzung der Qualität der Solarzelle.

Zudem können beim Ätzen der Frontelektrodenschicht, insbesondere im Falle ohne einer Ätzstopp-Schicht, bis zum Substrat reichende Vertiefungen entstehen, die zu Löchern in der Frontelektrodenschicht an deren dem Substrat zugewandten Grenzfläche führen. Grenzflächenbereiche der Frontelektrodenschicht mit fehlendem Metalloxid haben sowohl eine schlechtere optische Anpassung durch einen Brechnungsindexsprung mit fehlender Lichtstreuung als auch eine fehlende Querleitfähigkeit zur Sammlung der generierten Ladungsträger zur Folge, was sich in einem geringerem Füllfaktor niederschlagen kann.

Um die Bildung solcher Löcher zu verhindern, kann zwar eine dicke Ausgangsschicht für die Frontelektrodenschicht und eine relative kurze Ätzzeit angewendet werden. Eine solche dicke Ausgangsschicht ist jedoch nicht nur mit höheren Kosten verbunden, sie muss zudem niedrig dotiert sein, da sie ansonsten auch nach dem Ätzen eine zu hohe Lichtabsorption aufweist. Eine Frontelektrodenschicht mit geringer Dotiermenge erfordert zudem beispielsweise beim Sputtern eine vergleichsweise hohe Depositionstemperatur, sodass sich beim anschließenden Ätzen überhaupt keine geeignete Texturierung mehr ausbilden kann. Überdies führt eine derart dicke Ausgangsschicht zu einem Auftreten von Rissen aufgrund innerer Spannungen.

Aufgabe der Erfindung ist es daher, ein Substrat mit einer Frontelektrodenschicht bereitzustellen, mit dem eine Solarzelle hoher Qualität und hohem Wirkungsgrad hergestellt werden kann.

Dies wird erfindungsgemäß mit dem im Anspruch 1 gekennzeichneten Substrat mit darauf abgeschiedener Frontelektrodenschicht erreicht. In den Ansprüchen 2 bis 7 sind bevorzugte Ausführungsformen des mit der Elektrodenschicht versehenen Substrats angegeben. Der Anspruch 8 hat ein bevorzugtes Verfahren zur Herstellung des erfindungsgemäßen mit der Frontelektrodenschicht versehenen Substrats zum Gegenstand. Durch die Ansprüche 9 bis 13 wird das erfindungsgemäße Verfahren in vorteilhafter Weise weiter ausgestaltet.

Erfindungsgemäß bestehen die kegel- oder trichterförmigen Vertiefungen oder Krater, mit denen die Frontelektrodenschicht texturiert ist, aus wenigstens zwei kegelförmigen Abschnitten mit unterschiedlichem Kegelöffnungswinkel. Dabei weist der dem Substrat zugewandte, erste Vertiefungsabschnitt einen größeren Öffnungswinkel auf als der zweite, von dem Substrat abgewandte Vertiefungsabschnitt der Frontelektrodenschicht. Das heißt, der dem Substrat zugewandte erste Vertiefungsabschnitt ist durch seinen größeren Öffnungswinkel flacher ausgebildet als der zweite Vertiefungsabschnitt, der an der von dem Substrat abgewandten Seite der Frontelektrodenschichtvorgesehen und als Kegelstumpf ausgebildet ist, wobei an die Deckfläche des Kegelstumpfes die Basisfläche des ersten Vertiefungsabschnitts anschließt. Die Kegelachsen der beiden kegelförmigen Abschnitte der Vertiefungen fluchten miteinander. Die kegelförmigen Vertiefungen in der Frontelektrodenschicht weisen somit jeweils einen ersten kegelförmigen Vertiefungsabschnitt und einen zweiten als Kegelstumpf ausgebildeten, kegelförmigen Vertiefungsabschnitt mit einem kleineren Kegelöffnungswinkel als der erste Vertiefungsabschnitt sowie eine gemeinsame Kegelachse auf.

Insbesondere nano- und mikrokristallines Silizium wächst als Halbleiter im Wesentlichen senkrecht auf der Oberfläche der Frontelektrodenschicht auf. Durch den großen Öffnungswinkel des ersten Abschnitts der Vertiefungen der Frontelektrodenschicht wird ein relativ flacher Boden in den Vertiefungen geschaffen, auf dem der Halbleiter bis zur Öffnung der Vertiefung und dann darüber hinaus im Wesentlichen senkrecht aufwachsen kann, sodass im Wesentlichen keine Verschneidungen oder dergleichen Störungen mehr auftreten. Dadurch wird eine hohe Qualität der Halbleiterschicht und damit der Solarzelle sichergestellt.

Andererseits ist die Wandung der Vertiefungen in dem zweiten, also der Öffnung der Vertiefung zugewandten Vertiefungsabschnitt durch den kleineren Kegelöffnungswinkel relativ steil, wodurch ein hohes "Light Trapping" und damit ein hoher Wirkungsgrad der Solarzelle erzielt wird.

Vorzugsweise weist der erste, dem Substrat zugewandte kegelförmige Vertiefungsabschnitt einen Kegelöffnungswinkel von 130 bis 160, insbesondere 135 bis 150° auf, während der Kegelöffnungswinkel des zweiten, vom Substrat abgewandten kegelförmigen Vertiefungsabschnitts 115 bis 145°, insbesondere 120 bis 135° beträgt. Der Kegelöffnungswinkel des ersten und des zweiten Vertiefungsabschnitts der Vertiefungen stellen dabei jeweils die Kegelöffnungswinkel der zentrisch geschnittenen kegelförmigen Vertiefungen dar, wobei bei einer gerundeten oder in anderer Weise abgestumpften Spitze des ersten, dem Substrat zugewandten kegelförmigen Vertiefungsabschnitts die gerundete bzw. abgestumpfte Spitze bei der Winkelbestimmung unberücksichtigt bleibt.

Weiterhin hat es sich als vorteilhaft herausgestellt, um bei einem hohen "Light Trapping" ein im Wesentlichen ungestörtes senkrechtes Aufwachsen der Halbleiterschicht sicherzustellen, den zweiten, vom Substrat abgewandten kegelförmigen Vertiefungsabschnitten höher auszubilden als den ersten, flacheren, dem Substrat zugewandten kegelförmigen Vertiefungsabschnitt.

Vorzugsweise beträgt dabei die Höhe des zweiten, vom Substrat abgewandten kegelförmigen Vertiefungsabschnitt 100 bis 800 nm, insbesondere 150 bis 600 nm, und die Höhe des ersten, dem Substrat zugewandten, kegelförmigen Vertiefungsabschnitt 5 bis 250 nm, insbesondere 10 bis 100 nm. Die Schichtdicke der Frontelektrodenschicht von der Kegelspitze des ersten, dem Substrat zugewandten kegelförmigen Vertiefungsabschnitts bis zu der dem Substrat zugewandten Grenzfläche der Frontelektrodenschicht beträgt vorzugsweise bis zu 650 nm, vorzugsweise 10 bis 350 nm. Die Gesamtdicke der Frontelektrodenschicht beträgt vorzugsweise 350 bis 1200 nm, insbesondere 400 bis 800 nm. Das heißt, die Frontelektrodenschicht kann relativ dünn ausgebildet sein und damit eine entsprechend geringe Lichtabsorption aufweisen.

Der Durchmesser der Vertiefung an deren von dem Substrat abgewandter Öffnung beträgt vorzugsweise 500 bis 3500 nm, insbesondere 1000 bis 2500 nm und der Durchmesser der Vertiefung am Übergang des ersten kegelförmigen Vertiefungsabschnitts und des zweiten kegelförmigen Vertiefungsabschnitts 5 bis 1500 nm, insbesondere 50 bis 450 nm.

Die o. a. Werte der Kegelöffnungswinkel, der Höhe der kegelförmigen Vertiefungsabschnitte, des Durchmessers der Öffnung der Vertiefung und des Übergangs von dem ersten zum zweiten Vertiefungsabschnitt usw. stellen dabei Median-Werte dar.

Neben den vorstehend geschilderten Vertiefungen kann die von dem Substrat abgewandte Seite der Frontelektrodenschicht auch kleinere durch geringfügige Ätzangriffe gebildete Vertiefungen aufweisen, die jedoch nur eine geringe Tiefe bzw. Höhe von beispielsweise weniger als 50 % der Gesamthöhe der in Rede stehenden aus den wenigstens zwei Abschnitten mit unterschiedlichen Kegelöffnungswinkel bestehenden kegelförmigen Vertiefungen und einen Durchmesser von höchstens 30 % an der von dem Substrat abgewandten Öffnung gegenüber diesen Vertiefungen mit unterschiedlichen Kegelöffnungswinkel aufweisen. Auch diese Prozentangaben stellen Median-Werte dar.

Das transparente Substrat, auf dem die Frontelektrodenschicht abgeschieden wird, ist vorzugsweise Glas.

Das transparente, elektrisch leitfähige Metalloxid, aus dem die Frontelektrodenschicht besteht, ist vorzugsweise dotiertes Zinkoxid, insbesondere mit Aluminium, Gallium und/oder Bor dotiertes Zinkoxid. Es kann jedoch beispielsweise auch dotiertes Zinnoxid, beispielsweise mit Fluor dotiertes Zinnoxid, oder aus einem Gemisch aus Indiumoxid und Zinnoxid gebildet sein.

Zwischen dem Substrat und der Frontelektrodenschicht kann eine Zwischenschicht beispielsweise eine Siliziumoxid-Schicht, Siliziumnitrid-Schicht oder Titanoxid-Schicht zur optischen Anpassung der Brechnungsindices des Substrat, also z. B. des Glases an die Frontelektrodenschicht und/oder als Diffusionsbarriere zwischen dem Substratglas und den übrigen Schichten der Solarzelle vorgesehen sein.

Zur Herstellung der Dünnschichtsolarzelle werden auf der Frontelektrodenschicht eine Halbleiterschicht und eine Rückelektrodenschicht aufeinander abgeschieden.

Die Halbleiterschicht besteht vorzugsweise aus nano- oder mikrokristallinem Silizium. Sie kann jedoch auch aus amorphem Silizium bestehen oder einem anderen Halbleiter, beispielsweise Silizium-Germanium. Die Halbleiterschicht kann eine Single-Junction, eine Tandem-Schicht oder eine Multi-Junction-Schicht sein mit einer Schichtfolge von p-, i- und n-Teilschichten.

Die Rückelektrodenschicht kann aus einem Metall bestehen und zudem lichtreflektierend ausgebildet sein. Auch kann sich eine Reflexionsschicht an die Rückelektrodenschicht anschließen.

Vorzugsweise wird das erfindungsgemäße mit der texturierten Frontelektrodenschicht versehene Substrat dadurch erhalten, dass die Frontelektrodenschicht nach ihrer Abscheidung auf dem Substrat durch Ätzen texturiert wird und dabei aus wenigstens zwei Teilschichten besteht. Die dem Substrat zugewandte zuerst abgeschiedene erste Teilschicht ist dabei mit einer geringeren Ätzrate ätzbar, während die danach abgeschiedene, von dem Substrat abgewandte, zweite Teilschicht mit einer höheren Ätzrate, also schneller ätzbar ist. Dadurch wird in der von dem Substrat abgewandten zweiten Teilschicht der zweite kegelförmige Vertiefungsabschnitt gebildet, der einen kleineren Öffnungswinkel aufweist als der erste, dem Substrat zugewandte Vertiefungsabschnitt der Vertiefungen in der texturierten Frontelektrodenschicht. Die Abscheidung der Frontelektrodenschicht kann durch chemische Dampfabscheidung (CVD), beispielsweise plasmaunterstützte chemische Dampfabscheidung (PECVD) erfolgen, wird jedoch vorzugsweise durch Sputter-Deposition, insbesondere Magnetronsputtern durchgeführt.

Als Grundgas wird beim Sputtern vorzugsweise Argon oder ein anderes Edelgas verwendet.

Um der zuerst abgeschiedenen, ersten Teilschicht der Frontelektrodenschicht eine langsamere Ätzbarkeit zu verleihen als der danach abgeschiedenen zweiten Teilschicht, die mit einer höhere Ätzrate, also schneller ätzbar ist, können verschiedene Maßnahmen durchgeführt werden.

So kann die Ätzbarkeit der zuerst abgeschiedenen ersten Teilschicht durch eine höhere Substrat-Temperatur und/oder einen niedrigeren Depositions-Druck beim Sputtern herabgesetzt werden oder eine höhere Dotiermenge bei einer Frontelektrodenschicht aus einem dotierten Metalloxid. Ferner kann die Entladungsleistung, also die zur Plasmaerzeugung beim Sputtern aufgewendete Leistung beim Sputtern der zuerst abgeschiedenen, dem Substrat zugewandten, ersten Teilschicht größer als beim Sputtern der danach abgeschiedenen, von dem Substrat abgewandten, zweiten Teilschicht sein. Wenn ein reaktives Sputtern mit Sauerstoff als Reaktionsgas durchgeführt wird, kann zudem die Sauerstoff-Beigabe beim Sputtern der zuerst abgeschiedenen, dem Substrat zugewandten, ersten Teilschicht geringer als beim Sputtern der danach abgeschiedenen, vom Substrat abgewandten, zweiten Teilschicht sein.

Abgesehen von der Ätzbarkeit mit geringer Ätzrate werden bei der zuerst abgeschiedenen, dem Substrat zugewandten, ersten Teilschicht die Positionsparameter gewählt, die sich nach den Kosten, also möglichst niedrige Temperatur und den elektrooptischen Eigenschaften, also eine möglichst hohe Beweglichkeit der freien Ladungsträger richten. Die Depositionsparameter der von dem Substrat abgewandten zweiten Teilschicht werden optimiert nach den Zielen: niedrige Kosten, also möglichst niedrige Substrat-Temperatur, gute elektrooptische Eigenschaften, beispielsweise eine Ladungsträgerdichte in einem optimalen Bereich von 1 x 10²⁰ cm³ bis 8 x 10²⁰ cm³ und einer Beweglichkeit möglichst oberhalb von ca. 30 cm²/Vs.

Beispielsweise kann durch Sputtern eine Teilschicht aus mit 2 Gewichts-% Aluminiumoxid dotierten Zinkoxid bei einer Substrattemperatur von 200°C und einem Depositions-Druck von 1,3 Pa mit einer Ätzrate von 17 nm/sec deponiert werden und im Vergleich dazu eine Zinkoxid-Teilschicht mit gleicher Dotierung mit einer deutlich geringeren Ätzrate von 7 nm/sec bei der gleichen Substrattemperatur, jedoch einem Depositionsdruck von 0,1 Pa.

Bezüglich des Einflusses der Leistung auf die Ätzrate berichten Bunte et al (Proceedings 23rd EUPVSEC, Valencia, Spain, 2008, Seiten 2105 bis 2108), dass eine bei einer Entladungsleistung von 2 kW bzw. 4 kW gesputterte Schicht eine Ätzrate von 4,4 nm/sec bzw. 3,5 nm/sec besitzt und bei einer höheren Leistung von 14 kW bei ansonsten gleichen Bedingungen nur eine Ätzrate von 1,7 nm/sec.

Dies macht deutlich, dass einzelne, zumindest aber eine Kombination mehrerer Depositionsparameter zu Teilschichten mit deutlich niedrigeren Ätzraten führen kann.

Da der erste, dem Substrat zugewandte kegelförmige Vertiefungsabschnitt der Vertiefungen in der Frontelektrodenschicht flacher ausgebildet ist als der zweite, von dem Substrat abgewandte Vertiefungsabschnitt, ist erfindungsgemäß verhindert, dass bis zum Substrat reichende Vertiefungen gebildet werden, die zu Löchern in der Frontelektrodenschicht von der dem Substrat zugewandten Grenzfläche der Frontelektrodenschicht und damit zu einer Herabsetzung der Lichtstreuung und der Querleitfähigkeit der Frontelektrodenschicht führen. Das heißt, erfindungsgemäß wird vorzugsweise weniger als 3 %, besonders bevorzugt weniger als 1 %, insbesondere weniger als 0,5 % der dem Substrat zugewandten Grenzfläche der Frontelektrodenschicht aus Löchern gebildet, die durch sich zu dieser Grenzfläche erstreckenden Vertiefungen gebildet werden.

Um ein solches Durchätzen der Frontelektrodenschicht bis zu der dem Substrat zugewandten Grenzfläche zu verhindern, kann das Ätzen vorzugsweise in wenigstens zwei Phasen, also Zeitabschnitten durchgeführt werden, wobei in der ersten Phase nur die zweite Teilschicht und nach dem Durchätzen der zweiten Teilschicht in der zweiten Phase die erste und die zweite Teilschicht gemeinsam geätzt werden. Dabei wird das Ätzen während der ersten Phase mit einer höheren Ätzrate durchgeführt als in der zweiten Phase.

Das Ätzen erfolgt vorzugsweise durch Nassätzen mit einer Säure, beispielsweise Salzsäure, die mit einem Salz, beispielsweise einem Salz des Metalls des Metalloxids der Halbleiterschicht versetzt sein kann.

Um die Ätzrate während der ersten Phase zu erhöhen, kann eine höhere Temperatur der Ätzlösung, eine höhere Säurekonzentration der Ätzlösung oder eine Säure mit einem höheren Säureexponenten als während der zweiten Phase oder eine Kombination dieser Maßnahmen angewendet werden. So haben Versuche ergeben, dass eine in gleicher Weise durch Sputtern auf einem Glassubstrat abgeschiedene Frontelektrodenschicht gleicher Zusammensetzung aus mit Aluminiumoxid dotiertem Zinkoxid und gleicher Dicke nach dem Ätzen mit HCl-Dampf bei Raumtemperatur in einem Scanfeld von 20 x 7 µm² nach 35 Sekunden ca. 10 Bereiche mit einem Durchmesser von bis zu ca. 2 µm aufweist, nach dem Ätzen mit einer HCl-Lösung bei Raumtemperatur nach 35 Sekunden ca. drei freigelegte Substratbereiche mit einer Größe von bis zum 1 µm und nach dem Ätzen mit der gleichen HCl-Lösung anfänglich 10 Sekunden bei Raumtemperatur gefolgt von einem weiteren Ätzen bei einem Temperatur nahe dem Gefrierpunkt keine freigelegten Substratbereiche mehr. Die drei Schichten wiesen nach dem Ätzen einen vergleichbar großen elektrischen Flächenwiderstand auf, was ein Maß dafür ist, dass eine insgesamt vergleichbar große Menge Zinkoxid nach dem Ätzen auf dem Substrat verblieben ist.

Damit kann durch eine entsprechend abgeänderte Ätzdurchführung das Auftreten der durchgeätzten Substratsbereiche beispielsweise durch Ätzen bei einer niedrigen Temperatur verhindert werden. Daneben kann die Ätzung in mehreren Stufen bei unterschiedlichen Temperaturen, unterschiedlichen Säurekonzentrationen oder mit Säuren unterschiedlicher Säureexponenten durchgeführt werden. Dies ist produktionstechnisch auch realisierbar, da die Ätzung in mehreren Stationen einer Durchlaufanlage zur Herstellung von Dünnschichtsolarzellen erfolgt.

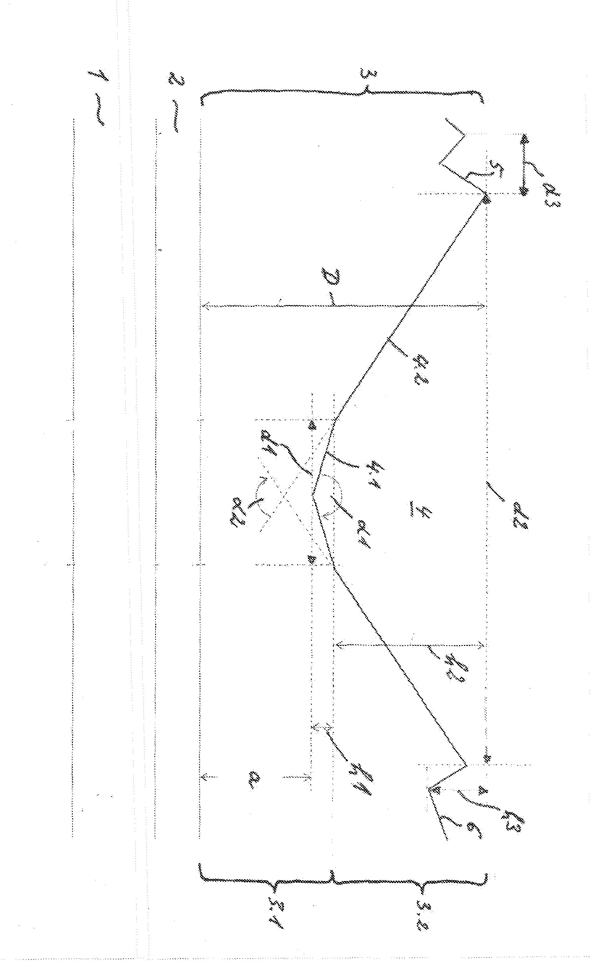

Nachstehend ist die Erfindung anhand der beigefügten Zeichnung beispielhaft näher erläutert, deren einzige Figur einen Schnitt durch ein Substrat mit darauf abgeschiedener, texturierter Frontelektrodenschicht zeigt.

Danach ist auf einem z. B. aus Glas bestehenden Substrat 1 eine Zwischenschicht 2 beispielsweise aus SiNₓ oder TiO₂ abgeschieden und auf der Zwischenschicht 2 eine Frontelektrodenschicht 3 aus einem transparenten, elektrisch leitfähigen Metalloxid, beispielsweise eine mit Aluminium dotierte Zinkoxidschicht. Die Frontelektrodenschicht 3 ist mit kegelförmigen Vertiefungen oder Kratern entsprechend der dargestellten Vertiefung 4 texturiert.

Die Frontelektrodenschicht 3 besteht aus zwei Teilschichten, nämlich einer ersten Teilschicht 3.1, die auf dem mit der Zwischenschicht 2 versehenen Substrat 1 abgeschieden ist und einer danach auf der ersten Teilschicht 3.1 abgeschiedenen zweiten Teilschicht 3.2, wobei in der Zeichnung nur der Teil der Frontelektrodenschicht 3 bzw. der zweiten Teilschicht 3.2 dargestellt ist, der nach dem Ätzen der Frontelektrodenschicht 3 zurückbleibt.

Die Vertiefung 4 und die übrigen entsprechend ausgebildeten Vertiefungen in der Rückelektrodenschicht 3 bestehen aus zwei konzentrischen, als gerade Kegel ausgebildeten Abschnitten 4.1 und 4.2. Der erste kegelförmige Abschnitt 4.1 der Vertiefung 4, der dem Substrat 1 zugewandt ist, weist einen Kegelöffnungswinkel α1 und der zweite kegelförmige Abschnitt 4.2 Vertiefung 4, der von dem Substrat 1 abgewandt ist, einen Kegelöffnungswinkel α2 auf, der kleiner ist als der Kegelöffnungswinkel α1. Der Kegelöffnungswinkel α1 des ersten Vertiefungsabschnitts 4.1 beträgt dabei vorzugsweise zwischen 135 und 150° und der Kegelöffnungswinkel α2 des zweiten Vertiefungsabschnitts 4.2 120 bis 135°. Dabei ist in der Zeichnung ein zentrischer, also durch die gemeinsame Kegelachse der beiden kegelförmigen Abschnitte 4.1 und 4.2 verlaufender Schnitt durch die Vertiefung 4 wiedergegeben. Der zweite kegelförmige Abschnitt 4.2 wird durch einen Kegelstumpf gebildet, an dessen dem Substrat 1 zugewandter Deckfläche die Basisfläche des Kegels des ersten Abschnitts 4.1 anschließt.

Die Höhe h1 des ersten kegelförmigen Vertiefungsabschnitts 4.1 ist kleiner als die Höhe h2 des zweiten kegelförmigen Vertiefungsabschnitts 4.2. So beträgt die Höhe h1 des ersten kegelförmigen Vertiefungsabschnitts 4.1, vorzugsweise 10 bis 100 nm und die Höhe h2 des zweiten kegelförmigen Vertiefungsabschnitts 4.2 150 bis 600 nm. Der Durchmesser d1 der Vertiefung 4 am Übergang von dem ersten kegelförmigen Vertiefungsabschnitt 4.1 zu dem zweiten kegelförmigen Vertiefungsabschnitt 4.2 beträgt vorzugsweise 50 bis 450 nm und der Durchmesser d2 der Vertiefung 4 an deren von dem Substrat 1 abgewandter Öffnung vorzugsweise 1000 bis 2500 nm.

Während die Gesamtdicke D der Frontelektrodenschicht 3 vorzugsweise 400 bis 800 nm beträgt, weist die Vertiefung 4 mit ihrer durch den ersten kegelförmigen Vertiefungsabschnitt 4.1 gebildeten Kegelspitze einen Abstand a von der dem Substrat 1 zugewandten Grenzfläche der Frontelektrodenschicht 3 von vorzugsweise mindestens 10 nm auf, um zu verhindern, dass an der dem Substrat 1 zugewandten Grenzfläche der Frontelektrodenschicht 3 Löcher entstehen, die durch sich bis zu dieser Grenzfläche erstreckende Vertiefungen 4 gebildet werden.

Die Vertiefung 4 und die übrigen entsprechend ausgebildeten Vertiefungen in der Frontelektrodenschicht 3 werden nach der Abscheidung der Frontelektrodenschicht auf dem mit der Zwischenschicht 2 versehenen Substrat 1 durch Nassätzen der Frontelektrodenschicht gebildet.

Dabei wird der erste Vertiefungsabschnitt 4.1 durch Ätzen der Teilschicht 3.1 und der zweite Vertiefungsabschnitts 3.2 durch Ätzen der Teilschicht 3.2 der Frontelektrodenschicht gebildet, die gegenüber der in der Zeichnung dargestellten, nach dem Ätzen zurückbleibenden Frontelektrodenschicht 3 entsprechend dicker ausgebildet ist.

Damit sich der flachere Vertiefungsabschnitt 4.1 mit dem größeren Kegelöffnungswinkel α1 gegenüber dem steileren Vertiefungsabschnitt 4.2 mit dem kleineren Kegelöffnungswinkel α2 beim Ätzen ausbilden kann, weist die Teilschicht 3.1 der Frontelektrodenschicht 3 eine geringere Ätzbarkeit als die Teilschicht 3.1 auf, die eine Ätzbarkeit mit einer höheren Ätzrate besitzt.

Die beiden Teilschichten 3.1 und 3.2 der Frontelektrodenschicht werden durch Sputtern abgeschieden. Ihre unterschiedliche Ätzbarkeit wird durch unterschiedliche Parameter beim Sputterprozess erhalten.

So kann die erste Teilschicht 3.1 bei einer höheren Substrattemperatur, einem niedrigeren Depositionsdruck und/oder einer höheren Entladungsleistung zur Plasmaerzeugung bei der Sputterdeposition erhalten werden als die zweite Teilschicht 3.2, um der ersten Teilschicht 3.1 eine geringere Ätzbarkeit als der zweiten Teilschicht 3.2 zu verleihen. Statt dessen oder zusätzlich kann bei einer Frontelektrodenschicht aus einem dotiertem Metalloxid, beispielsweise mit Al₂O₃ dotiertem ZnO, die Ätzbarkeit der ersten Teilschicht 3.1 gegenüber der Ätzbarkeit der zweiten Teilschicht 3.2 durch eine höhere Dotiermenge beim Sputtern der ersten Teilschicht 3.1 als beim Sputtern der zweiten Teilschicht 3.2 oder bei Zugabe von Sauerstoff als reaktivem Gas beim Sputtern durch eine geringere Sauerstoffzugabe herabgesetzt werden.

Neben den aus zwei kegelförmigen Abschnitten 4.1 und 4.2 bestehenden Vertiefungen 4 kann die Frontelektrodenschicht 3 durch geringfügige Ätzangriffe gebildete weitere Vertiefungen um 5,6 aufweisen, deren Tiefe h3 weniger als 50 % der Höhe h2 des zweiten Kegelabschnitts 4.2 der Vertiefung 4 entspricht, wobei der Durchmesser d3 der Vertiefungen 5, 6 zwischen den gegenüberliegenden Erhöhungen, die sie begrenzen, höchstens 20 % des Durchmesser d2 beträgt.

## Patentansprüche

1. Substrat mit einer darauf abgeschiedenen, mit kegelförmigen Vertiefungen (4) texturierten Frontelektrodenschicht (3) aus einem transparenten, elektrisch leitfähigen Metalloxid zur Herstellung einer Solarzelle, welche eine auf der Frontelektrodenschicht (3) abgeschiedene Halbleiterschicht und eine Rückelektrodenschicht aufweist, **dadurch gekennzeichnet, dass** die kegelförmigen Vertiefungen (4) aus wenigstens zwei Abschnitten (4.1 und 4.2) mit unterschiedlichen Kegelöffnungswinkeln (α1, α2) bestehen, wobei der erste, dem Substrat (1) zugewandte Vertiefungsabschnitt (4.1) einen größeren Kegelöffnungswinkel (α1) aufweist als der zweite von dem Substrat (1) abgewandte Vertiefungsabschnitt (4.2).

2. Substrat nach Anspruch 1 **dadurch gekennzeichnet, dass**, der Kegelöffnungswinkel (α1) des ersten Vertiefungsabschnitts (4.1) einen Kegelöffnungswinkel von 130 bis 160° und der zweite Vertiefungsabschnitt (4.2) einen Kegelöffnungswinkel von 115 bis 145° aufweist.

3. Substrat nach Anspruch 1 oder 2, **dadurch gekennzeichnet, dass** die Höhe (h1) des ersten Vertiefungsabschnitts (4.1) kleiner ist als die Höhe (h2) des zweiten Vertiefungsabschnitts (4.2).

4. Substrat nach einem der vorstehenden Ansprüche, **dadurch gekennzeichnet, dass** die Höhe (h1) des ersten Vertiefungsabschnitts (4.1) 5 bis 250 nm und die Höhe (h2) des zweiten Vertiefungsabschnitts 100 bis 800 nm beträgt.

5. Substrat nach einem der vorstehenden Ansprüche, **dadurch gekennzeichnet, dass** der Durchmesser (d2) der Vertiefung (4) an deren von dem Substrat (1) abgewandte Öffnung 500 bis 3500 nm und der Durchmesser (d1) der Vertiefung (4) am Übergang des ersten Vertiefungsabschnitts (4.1) zum zweiten Vertiefungsabschnitt (4.2) 5 bis 1500 nm beträgt.

6. Substrat nach einem der vorstehenden Ansprüche, **dadurch gekennzeichnet, dass** die gesamte Dicke (D) der Frontelektrodenschicht (3) 350 bis 1200 nm beträgt.

7. Substrat nach einem der vorstehenden Ansprüche, **dadurch gekennzeichnet, dass** weniger als 3 % der dem Substrat (1) zugewandten Grenzfläche der Frontelektrodenschicht (3) aus Löchern besteht, die durch sich bis zu dieser Grenzfläche erstreckende Vertiefungen (4) gebildet werden.

8. Verfahren zur Herstellung eines Substrats mit einer Frontelektrodenschicht nach einem der vorstehenden Ansprüche, **dadurch gekennzeichnet, dass** die Frontelektrodenschicht nach ihrer Abscheidung auf dem Substrat (1) durch Ätzen texturiert wird und aus wenigstens zwei Teilschichten (3.1 und 3.2) besteht, wobei die dem Substrat (1) zugewandte, erste Teilschicht (3.1) eine Ätzbarkeit mit einer geringeren Ätzrate aufweist als die von den Substrat (1) abgewandte, zweite Teilschicht (3.2), um in der ersten Teilschicht (3.1) den ersten Vertiefungsabschnitt (4.1) und in der zweiten Teilschicht (3.2) den zweiten Vertiefungsabschnitt (4.2) der Vertiefung (4) in der Frontelektrodenschicht (3) zu bilden.

9. Verfahren nach Anspruch 8, **dadurch gekennzeichnet, dass** die Abscheidung der Frontelektrodenschicht (3) durch Sputtern erfolgt.

10. Verfahren nach Anspruch 8 und 9, **dadurch gekennzeichnet, dass** die erste Teilschicht (3.1) zur Herabsetzung ihrer Ätzbarkeit gegenüber der zweiten Teilschicht (3.2) bei einer höheren Substrattemperatur als die zweite Teilschicht (3.2) gesputtert wird.

11. Verfahren nach Anspruch 8 und 9, **dadurch gekennzeichnet, dass** die erste Teilschicht (3.1) zur Herabsetzung ihrer Ätzbarkeit gegenüber der zweiten Teilschicht (3.2) bei einem niedrigeren Depositionsdruck als die zweite Teilschicht gesputtert wird.

12. Verfahren nach Anspruch 8 und 9, **dadurch gekennzeichnet, dass** die erste Teilschicht (3.1) zur Herabsetzung ihrer Ätzbarkeit gegenüber der zweiten Teilschicht (3.2) mit einer geringeren Dotiermenge als die zweite Teilschicht (3.2) gesputtert wird.

13. Verfahren nach Anspruch 8 und 9, **dadurch gekennzeichnet, dass** die erste Teilschicht (3.1) zur Herabsetzung ihrer Ätzbarkeit gegenüber der zweiten Teilschicht (3.2) bei einer höheren Beigabe eines reaktiven Gases zum Depositionsgemisch als die zweite Teilschicht (3.2) gesputtert wird.

14. Verfahren nach Anspruch 8 und 9, **dadurch gekennzeichnet, dass** die erste Teilschicht (3.1) zur Herabsetzung ihrer Ätzbarkeit gegenüber der zweiten Teilschicht (3.2) bei einer höheren Entladungsleistung als die zweite Teilschicht (3.2) gesputtert wird.

15. Verfahren nach Anspruch 8 und 9, **dadurch gekennzeichnet, dass** zum Sputtern eine Kombination von Maßnahmen nach wenigstens zwei der Ansprüche 10 bis 14 angewendet wird.

16. Verfahren nach einem der Ansprüche 8 bis 15 insbesondere zur Herstellung eines Substrats mit einer Frontelektrodenschicht nach Anspruch 7, **dadurch gekennzeichnet, dass** das Ätzen in wenigstens zwei Phasen durchgeführt wird, wobei in der ersten Phase nur die zweite Teilschicht (3.2) und nach Durchätzen der zweiten Teilschicht (3.2) in der zweiten Phase die erste und die zweite Teilschicht (3.1 und 3.2) geätzt werden, wobei das Ätzen in der ersten Phase mit einer höheren Ätzrate als in der zweiten Phase durchgeführt wird.

17. Verfahren nach einem der Ansprüche 8 bis16, **dadurch gekennzeichnet, dass** das Ätzen der Frontelektrodenschicht nasschemisch mit einer Säure durchgeführt wird.

18. Verfahren nach Anspruch 16 oder17, **dadurch gekennzeichnet, dass** das Ätzen während der ersten Phase bei einer höheren Temperatur und/oder einer höheren Säurekonzentration und/oder mit einer Säure mit einem höheren Säureexponenten als während der zweiten Phase durchgeführt wird.
